# EUROPÄISCHE PATENTANMELDUNG

(11) **EP 1 538 667 A2**
(43) Veröffentlichungstag der Anmeldung: **08.06.2005**
(21) Anmeldenummer: 04027052.2
(22) Anmeldetag: 13.11.2004
(51) Int. Cl.: H01L 23/373, H01L 23/495

(54) **Elektronisches Gerät mit elektrisch isoliertem metallischen Wärmeableitkörper**

(30) Priorität: 06.12.2003 DE 10357170
(71) Anmelder: LuK Lamellen und Kupplungsbau Beteiligungs KG, 77815 Bühl (DE)
(72) Erfinder: Hill, Wolfgang, 76135 Karlsruhe (DE)

(57) **Zusammenfassung**

Ein Elektronisches Gerät weist mindestens einen Halbleiterchip auf, der an einer Kontaktseite flächig mit wenigstens einem metallischen Leiterteil elektrisch leitend verbunden ist. Das Leiterteil ist an seiner dem Halbleiterchip abgewandten Rückseite flächig mit einem metallischen Wärmeableitkörper verbunden. Zwischen dem Leiterteil und dem Wärmeableitkörper ist eine elektrisch isolierende Folie angeordnet. Zwischen der Folie und dem Leiterteil und/oder zwischen der Folie und dem Wärmeableitkörper ist eine weiche metallische Schicht vorgesehen.

## Beschreibung

Die Erfindung betrifft ein elektronisches Gerät mit mindestens einem Halbleiterchip, der an mindestens einer Kontaktseite flächig mit wenigstens einem metallischen Leiterteil elektrisch leitend verbunden ist, wobei das Leiterteil an seiner dem Halbleiterchip abgewandten Rückseite flächig mit einem metallischen Wärmeableitkörper verbunden ist, wobei zwischen dem Leiterteil und dem Wärmeableitkörper eine elektrisch isolierende Folie angeordnet ist.

Ein derartiges elektrisches Gerät ist aus der Praxis bekannt. Es weist in Halbleiterchips integrierte Leistungstransistoren auf, die an ihrer Rückseite flächig mit Leiterteilen aus Kupfer elektrisch leitend verbunden sind. Die Leiterteile sind durch Einzelteile eines Stanzgitters gebildet. An ihrer Vorderseite sind die Halbleiterchips jeweils über Bonddrähte kontaktiert. Die beim Betrieb des elektrischen Geräts in den Halbleiterchips entstehende Verlustwärme wird flächig auf die Leiterteile übertragen. Diese sind jeweils an ihrer dem Halbleiterchip abgewandten Rückseite flächig mit einem metallischen Wärmeableitkörper verbunden, der die Verlustwärme von den Leiterteilen an die Umgebung ableitet. Die einzelnen Leiterteile weisen unterschiedliche elektrische Potentiale auf und sind daher gegeneinander und gegen den Wärmeableitkörper elektrisch isoliert. Zwischen den Leiterteilen und dem Wärmeableitkörper ist zu diesem Zweck eine elektrisch isolierende Folie angeordnet, die über eine an der einen Seite der Folie angeordnet erste Klebstoffschicht mit den Leiterteilen und über eine an der gegenüberliegenden anderen Seite der Folie angeordnete zweite Klebstoffschicht mit dem Wärmeableitkörper stoffschlüssig verbunden ist. Die Dicke der Folie und der Klebstoffschichten ist so bemessen, dass die aus den Klebstoffschichten und der Folie gebildete Schichtanordnung die in der Praxis auftretenden Unebenheiten und Ungenauigkeiten der einander zugewandten Flächen einerseits des Wärmeableitkörpers und andererseits der Leiterteile ausgleichen kann, so dass stets eine flächige, elektrisch isolierende Verbindung zwischen dem Wärmeableitkörper und den Leiterteilen vorhanden ist. Nachteilig ist dabei jedoch, dass sich aufgrund der relativ großen Dicke dieser Schichtanordnung ein entsprechend großer Wärmewiderstand der Schichtanordnung ergibt, der die Wärmeabführung von den Leiterteilen zu dem Wärmeableitkörper behindert. Es ist zwar auch bereits eine elektrisch isolierende Folie bekannt, die mit einem gut wärmeleitenden Keramikpulver befüllt ist. Diese Folie weist zwar gegenüber einer ungefüllten Kunststoff-Folie gleicher Dicke eine fünf- bis zehnfach höhere spezifische Wärmeleitfähigkeit auf. Durch das Keramikpulver ist die Folie jedoch sehr dick, wodurch der Vorteil der geringen spezifischen Wärmeleitfähigkeit teilweise wieder verloren geht. Ungünstig ist außerdem, dass derartige keramikpulvergefüllte Folien relativ teuer sind.

Es besteht deshalb die Aufgabe, ein elektronisches Gerät der eingangs genannten Art zu schaffen, das eine gut wärmeleitende, elektrisch Isolierende Verbindung zwischen dem wenigstens einen metallischen Leiterteil und dem Wärmeableitkörper aufweist.

Diese Aufgabe wird dadurch gelöst, dass zwischen der Folie und dem Leiterteil und/oder zwischen der Folie und dem Wärmeableitkörper eine weiche metallische Schicht angeordnet ist.

In vorteilhafter Weise kann dabei die metallische Schicht die in der Praxis nahezu unvermeidbaren Unebenheiten und Ungenauigkeiten der einander zugewandten Flächen des Wärmeableitkörpers und des wenigstens einen Leiterteils ausgleichen, so dass die Wandstärke der elektrisch isolierenden Folie entsprechend reduziert sein kann. Auch kann die metallische Schicht Oberflächenrauhigkeiten des Wärmeableitkörpers und/oder des wenigstens einen Leiterteils ausgleichen. Dennoch wird trotz der geringen Wandstärke der Folie eine sichere elektrische Isolation des Wärmeableitkörpers gegen das Leiterteil und eine flächige Wärmeübertragung zwischen dem Wärmeableitkörper und dem Leiterteil ermöglicht. Da die spezifische Wärmeleitfähigkeit der weichen metallischen Schicht wesentlich größer ist als die der elektrisch isolierenden Folie ergibt sich insgesamt eine deutliche Reduzierung des Wärmeübergangswiderstands zwischen dem wenigstens einen Leiterteil und dem Wärmeableitkörper. In scheinbar widersprüchlicher Weise wird also durch das Hinzufügen der beim Stand der Technik nicht vorhandenen weichen metallischen Schicht der Wärmeübergangswiderstand zwischen dem Leiterteil und dem Wärmeableitkörper nicht erhöht sondern reduziert.

Vorteilhaft ist, wenn mindestens eine metallische Schicht durch ein vorzugsweise weichgeglühtes Metallband gebildet ist. Das Metallband kann hierfür durch Walzen kostengünstig hergestellt werden, wobei die beim Walzen auftretende Aufhärtung des Metallband-Werkstoffs durch Weichglühen wieder beseitigt wird. Das Metallband besteht vorzugsweise aus Kupfer, Aluminium, Zinn oder einer Legierung aus diesen Metallen.

Bei einer bevorzugten Ausführungsform der Erfindung ist die Folie auf das Metallband aufkaschiert. Die metallisch beschichtete Folie ist dann bei der Fertigung des elektronischen Geräts besonders gut handhabbar. Das Metallband dient als Träger und schützt die Folie vor Beschädigungen. Das Aufkaschieren kann unter Wärmeund/oder Druckeinwirkung erfolgen.

Bei einer vorteilhaften Ausführungsform der Erfindung besteht mindestens eine metallische Schicht aus einem pastösen Werkstoff. Die Metallpaste kann Unebenheiten und Oberflächenrauhigkeiten des Wärmeableitkörpers und/oder des wenigstens einen Leiterteils besonders gut ausgleichen. Bei der Fertigung des elektrischen Geräts kann die Metallpaste im Siebdruckverfahren auf einfache Weise auf die Folie aufgebracht werden, um diese danach zusammen mit der Metallpaste an dem mindestens einen Leiterteil und/oder dem Wärmeableitkörper zu positionieren.

Bei einer zweckmäßigen Ausgestaltung der Erfindung sind wenigstens zwei Leiterteile seitlich durch mindestens einen Zwischenraum derart voneinander beabstandet, dass sie eine mehrere Leiterbahnen aufweisende Leiterbahnstruktur bilden, wobei die zwischen der Folie und den Leiterteilen angeordnete metallische Schicht eine Struktur aufweist, die der Leiterbahnstruktur angepasst und vorzugsweise etwa deckungsgleich mit dieser ist. Die Leiterteile der Leiterbahnstruktur können dann unterschiedliche Potentiale aufweisen und dennoch kann die Verlustwärme des Halbleiterchips über die Leiterteile auf denselben Wärmeableitkörper übertragen werden. Die Struktur der metallischen Schicht kann durch Aufbringen einer ätzbeständigen Maske und anschließendes Wegätzen der von der Maske nicht überdeckten Bereiche der metallischen Schicht erzeugt werden.

Vorteilhaft ist, wenn zumindest in dem mindestens einen Zwischenraum eine elektrisch isolierende Vergussmasse angeordnet ist, vorzugsweise ein Lack. Die Leiterteile sind dadurch besonders gut gegeneinander isoliert, auch dann, wenn das elektronische Gerät in einer feuchten und/oder verschmutzten Umgebung betrieben wird. Die Vergussmasse kann als Vollverkapselung aus Kunststoff ausgebildet sein, welche die Leiterteile und gegebenenfalls den mindestens einen Halbleiterchip dicht umschließt. Dabei kann die Vergussmasse gleichzeitig auch als Halterung dienen, welche die Leiterteile und den mindestens einen Halbleiterchip relativ zueinander positioniert.

Bei einer bevorzugten Ausführungsform der Erfindung beträgt die Dicke der Folie zwischen 12,5 µm und 25 µm. Die Folie kann also sehr dünn sein, was eine gute Wärmeübertragung von dem wenigstens einen Leiterteil auf den Wärmeableitkörper ermöglicht.

Vorteilhaft ist, wenn zwischen der Folie und dem Leiterteil eine vorzugsweise als Klebstoffschicht ausgebildete Zwischenschicht angeordnet ist, die an ihrer einen Seite das Leiterteil und an ihrer anderen Seite die Folie und/oder die zwischen dem Leiterteil und der Folie angeordnete metallische Schicht stoffschlüssig kontaktiert. Das elektronische Gerät ist dann noch kostengünstiger herstellbar. Da eventuelle Unebenheiten und Ungenauigkeiten der einander zugewandten Flächen des Wärmeableitkörpers und/oder des wenigstens einen Leiterteils durch die mindestens eine metallische Schicht ausgleichen werden, kann die Klebstoffschicht sehr dünn sein. Vorzugsweise wird die Klebschicht auf die Unterseite der Leiterteile aufgetragen und enthält Klebstoff einem gut wärmeleitenden Werkstoff.

Bei einer zweckmäßigen Ausgestaltung der Erfindung ist zwischen der Folie und dem Wärmeableitkörper eine vorzugsweise als Klebstoffschicht ausgebildete Zwischenschicht angeordnet, die an ihrer einen Seite den Wärmeableitkörper und an ihrer anderen Seite die Folie und/oder die zwischen dem Wärmeableitkörper und der Folie befindliche metallische Schicht stoffschlüssig kontaktiert. Auch diese Klebstoffschicht kann sehr dünn gewählt werden, um eine gute Wärmeübertragung von dem wenigstens einen Leiterteil auf den Wärmeableitkörper zu ermöglichen.

Vorteilhaft ist, wenn die Zwischenschicht Metallpartikel und/oder Keramikpartikel enthält. Die Zwischenschicht weist dann eine hohe Wärmeleitfähigkeit auf. Wenn die Zwischenschicht Metallpartikel enthält, wird außerdem die elektrische Leitfähigkeit der Zwischenschicht verbessert.

Nachfolgend sind Ausführungsbeispiele der Erfindung anhand der Zeichnung näher erläutert. Es zeigen:
- Fig. 1: einen Querschnitt durch ein erstes Ausführungsbeispiel der Erfindung, bei dem zwischen den Leiterteilen und dem Wärmeableitkörper eine elektrisch isolierende Kunststofffolie angeordnet ist, die beidseitig mit Weichmetallfolien beschichtet ist,
- Fig. 2: einen Querschnitt durch ein zweites Ausführungsbeispiel der Erfindung, bei dem die Kunststofffolie nur einseitig mit einer Weichmetallfolie beschichtet ist, wobei die Weichmetallfolie strukturiert ist, und
- Fig. 3: einen Querschnitt durch ein drittes Ausführungsbeispiel der Erfindung, bei dem die Kunststofffolie einseitig mit einer durchgängigen Weichmetallfolie beschichtet ist.

Ein im Ganzen mit 1 bezeichnetes, in der Zeichnung nur teilweise dargestelltes elektronisches Gerät weist mehrere als Leistungstransistoren ausgebildete Halbleiterchips 2 auf. Die Halbleiterchips 2 sind jeweils an einer ihrer Flachseiten über eine in der Zeichnung nicht näher dargestellte Lötmittelschicht mit mindestens einem metallischen Leiterteil 3 eines Stanzgitters flächig verbunden. Dieses besteht vorzugsweise aus Kupfer. Zueinander benachbart nebeneinander angeordnete Leiterteile 3 sind durch Zwischenräume 4 voneinander beabstandet.

Beim Betreiben des elektronischen Geräts tritt in den Halbleiterchips 2 Verlustwärme auf, die über die Lötmittelschicht an die Leiterteile 3 weitergeleitet wird. Die Leiterteile 3 sind jeweils an ihren dem Halbleiterchip abgewandten Rückseiten mit einem metallischen Wärmeableitkörper 5 flächig verbunden. An diesen Wärmeableitkörper 5 wird die in die Leiterteile 3 eingeleitete Verlustwärme der Halbleiterchips 2 abgeführt. Der Wärmeableitkörper 5 gibt die Verlustwärme an die Umgebung ab.

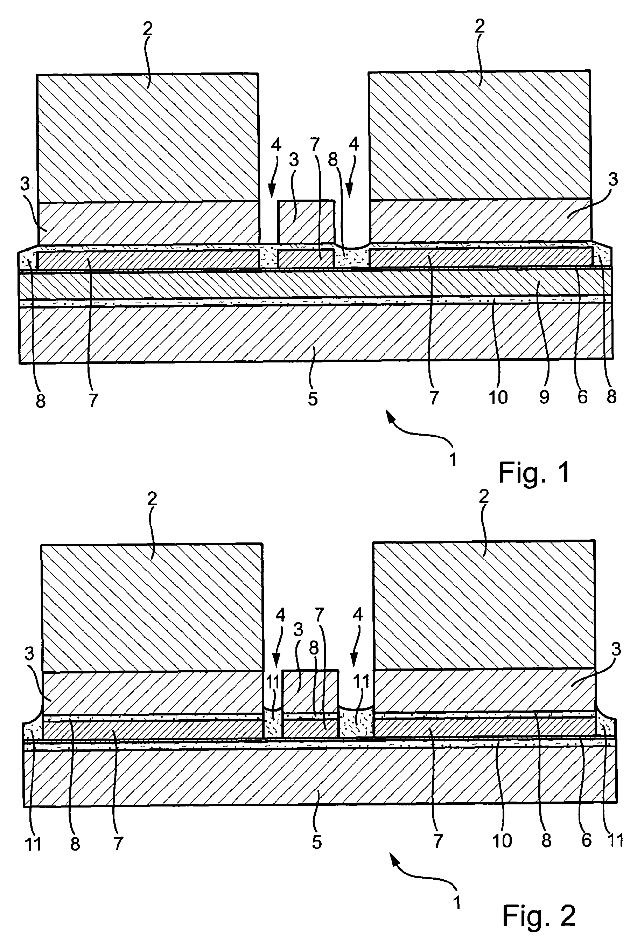

Zwischen den Leiterteilen 3 einerseits und dem Wärmeableitkörper 5 andererseits ist eine elektrisch isolierende, dünne Folie 6 angeordnet, deren Dicke etwa zwischen 12,5 µm und 25 µm beträgt. An ihrer den Leiterteilen 3 zugewandten Flachseite ist die Folie 6 mit einer ersten metallischen Schicht 7 beschichtet, die eine der Struktur des Stanzgitters entsprechende Struktur aufweist. In Fig. 1 ist deutlich erkennbar, dass die erste metallische Schicht 7 in den Zwischenräumen 4 zwischen seitlich zueinander benachbarten Leiterteilen 3 Unterbrechungen aufweist. Die erste metallische Schicht 7 besteht aus einem weichgeglühten Reinmetall, z.B. aus Kupfer, Aluminium oder Zinn. Durch die erste metallische Schicht 7 können Unebenheiten in den der Folie 6 zugewandten Oberflächenbereichen der Leiterteile 3 ausgeglichen werden. Die erste metallische Schicht 7 kann durch positives Metallisieren oder im Siebdruckverfahren auf die Folie 6 aufgebracht werden.

Bei dem in Fig.1 gezeigten Ausführungsbeispiel ist zwischen den Leiterteilen 3 und der ersten metallischen Schicht 7 eine dünne erste Klebstoffschicht 8 angeordnet, die sich durchgängig über sämtliche Halbleiterchips 2 erstreckt und aus einem elektrisch isolierenden Werkstoff besteht. Deutlich ist erkennbar, dass die erste Klebstoffschicht 8 auch in den Zwischenräumen 4 auf der Folie 6 angeordnet ist. Zur Verbesserung ihrer Wärmeleitfähigkeit enthält die erste Klebstoffschicht 8 ein Keramikpulver in einer Körnung, die vorzugsweise etwa der Dicke entspricht, den die erste Klebstoffschicht 8 in den zwischen den Leiterteilen 3 und der ersten metallischen Schicht 7 befindlichen Bereichen aufweist. Die erste Klebstoffschicht 8 ist an ihrer einen Flachseite stoffschlüssig mit den Leiterteilen 3 und an ihrer gegenüberliegenden anderen Flachseite stoffschlüssig mit der ersten metallischen Schicht 7 und der Folie 6 verbunden. Die Positionierfestigkeit wird überwiegend von dem Klebstoff in den Zwischenräumen 4 gewährleistet. In den zwischen den Leiterteilen 3 und der Folie 6 befindlichen Bereichen weist die erste Klebstoffschicht 8 eine geringere Dicke auf als in den Zwischenräumen 4.

An ihrer der ersten metallischen Schicht 7 abgewandten Flachseite ist die Folie 6 mit einer zweiten metallischen Schicht 9 beschichtet, die sich durchgängig über die Folie 6 erstreckt. Die zweite metallische Schicht 9 besteht aus einem weichgeglühten Reinmetall, z.B. aus Kupfer, Aluminium oder Zinn, das vorzugsweise dem Metall der ersten metallischen Schicht 7 entspricht. Durch die zweite metallische Schichte 9 können Unebenheiten in dem der Folie 6 zugewandten Oberflächenbereich des Wärmeableitkörpers 5 ausgeglichen werden.

Zwischen der zweiten metallischen Schicht 9 und dem Wärmeableitkörper 5 ist eine dünne zweite Klebstoffschicht 10 angeordnet, die als Leitkleber ausgebildet ist und ein Pulver aus einem gut leitfähigen Metall in einer Körnung enthält, die etwa der Dicke der zweiten Klebstoffschicht 10 entspricht oder etwas kleiner ist als diese. Die zweite Klebstoffschicht 10 ist an ihrer einen Flachseite stoffschlüssig mit der zweiten metallischen Schicht 9 und an ihrer anderen Flachseite stoffschlüssig mit dem Wärmeableitkörper 5 verbunden.

Bei dem in Fig. 2 gezeigten Ausführungsbeispiel weist die Folie 6 eine etwas größere Dicke auf als bei dem Ausführungsbeispiel nach Fig. 1. Eine zwischen den Leiterteilen 3 und der Folie 6 angeordnete metallische Schicht 7 ist durch eine strukturierte Metallpaste gebildet, die ein pastöses Trägermaterial enthält, in dem gut leitende Metallpartikel angeordnet sind. Die metallische Schicht 7 weist eine etwa dem Stanzgitter entsprechende Formgebung mit mehreren durch Zwischenräume 4 voneinander beabstandeten Bereichen auf. Bei der Herstellung des elektronischen Geräts 1 wird die metallische Schicht vorzugsweise im Siebdruckverfahren auf die Folie 6 aufgebracht. Nach dem Abbinden eines in der Metallpaste angeordneten Bindemittels weist die Metallpaste eine relativ weiche Konsistenz auf. Bei der Herstellung des elektronischen Geräts 1 wird die erste Klebstoffschicht 8 nach dem Abbinden der Metallpaste entweder auf die Leiterteile 3 oder auf die metallische Schicht 7 aufgeräkelt. Unmittelbar danach erfolgt der Montagevorgang, wobei die Leiterteile 3 exakt auf der strukturierten metallischen Schicht 7 positioniert werden. In Fig. 2 ist deutlich erkennbar, dass die erste Klebstoffschicht 8 nur zwischen den Leiterteilen 3 und der Folie 6 vorgesehen ist, während sie in den Zwischenräumen 4 jeweils unterbrochen ist. Durch die metallische Schicht 7 können Unebenheiten in den der Folie 6 zugewandten Oberflächenbereichen der Leiterteile 3 ausgeglichen werden.

Die aus den Halbleiterchips 2, den Leiterteilen 3, der ersten Klebstoffschicht 8 und der Folie gebildete Anordnung wird anschließend auf den Wärmeableitkörper 5 montiert, auf den zuvor die zweite Klebstoffschicht 10 aufgetragen wurde. Bei diesem Montageschritt kann die metallische Schicht 7 eventuelle Unebenheiten in der der Folie 6 zugewandten Oberfläche des Wärmeableitkörpers 5 ausgleichen, um den flächigen Kontakt zwischen der Folie 6 und dem Wärmeableitkörper 5 herzustellen. In Fig. 2 ist erkennbar, dass die der metallischen Schicht 7 abgewandte Flachseite der Folie 6 nach der Montage direkt über die zweite Klebstoffschicht 10 mit dem Wärmeableitkörper 5 verbunden ist. Die Folie 6 ist also nur einseitig mit einer Metallschicht 7 beschichtet.

Die gesamte Baugruppe wird nun mit einer elektrisch isolierenden Vergussmasse 11, nämlich einem Isolieriack, überzogen. In Fig. 2 ist diese Vergussmasse 11 in den Zwischenräumen 4 zwischen den Leiterteilen 3 deutlich erkennbar. Die Vergussmasse 11 ermöglicht eine gute elektrische Isolation der Leiterteile 3 gegeneinander.

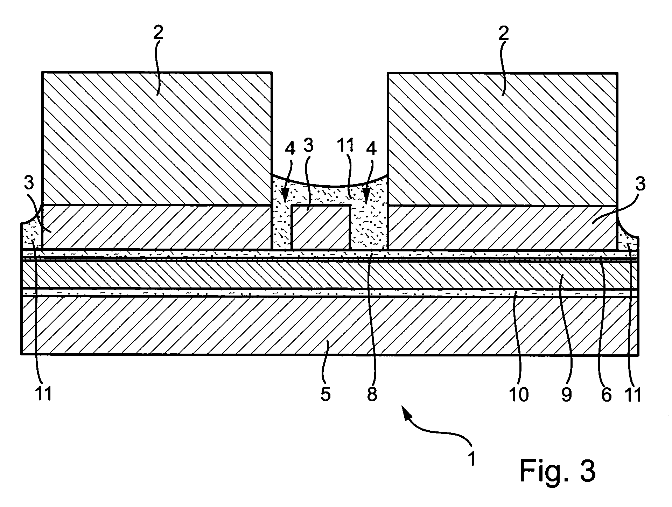

Auch bei dem in Fig. 3 gezeigten Ausführungsbeispiel ist die Folie 6 nur einseitig mit einer metallischen Schicht 9 beschichtet. Diese ist zwischen der Folie 6 und dem Wärmeableitkörper 5 angeordnet. Bei dieser kostengünstigen Ausführungsform ist die metallische Schicht 9 durch ein weiches, unstrukturiertes Metallband gebildet, das auf die Folie 6 aufkaschiert ist. Das Metallband schützt die Folie 6, indem es Unebenheiten ausgleicht. Zwischen der Folie 6 und den Leiterteilen 3 ist eine elektrisch isolierende erste Klebstoffschicht 8 angeordnet, die an ihrer einen Flachseite stoffschlüssig mit den Leiterteilen 3 und an ihrer gegenüberliegenden anderen Flachseite stoffschlüssig mit der Folie 6 verbunden ist. Bei der Herstellung des elektronischen Geräts 1 wird die erste Klebstoffschicht 8 zunächst flächig auf die Folie 6 aufgebracht und danach wird die aus den Halbleiterchips 2 und den Leiterteilen 3 bestehende Baugruppe an der ersten Klebstoffschicht 8 positioniert.

Anstelle einer elektrisch isolierenden, unstrukturierten ersten Klebstoffschicht 8 kann auch eine elektrisch leitfähige, strukturierte Klebstoffschicht 8 vorgesehen sein. In diesem Fall wird die erste Klebstoffschicht 8 bei der Herstellung des elektronischen Geräts 1 flächig auf die Leiterteile 3 aufgetragen, um diese danach an der Folie 6 zu positionieren.

Zwischen der metallischen Schicht 9 und dem Wärmeableitkörper 5 ist eine gut wärmeleitende zweite Klebstoffschicht 10 vorgesehen, welche an ihrer einen Flachseite die metallische Schicht 9 und an ihrer anderen Flachseite den Wärmeableitkörper 5 direkt kontaktiert. Anstelle der zweiten Klebstoffschicht 10 kann auch ein Niedertemperaturlot vorgesehen sein.

Auch bei dem Ausführungsbeispiel nach Fig. 3 ist zwischen den Leiterteilen 3 eine elektrisch isolierende Vergussmasse 11 angeordnet.

### Bezugszeichenliste

- 1: elektronisches Gerät
- 2: Halbleiterchip
- 3: Leiterteil
- 4: Zwischenraum
- 5: Wärmeableitkörper
- 6: Folie
- 7: metallische Schicht
- 8: erste Klebstoffschicht
- 9: metallische Schicht
- 10: zweite Klebstoffschicht
- 11: Vergussmasse

## Patentansprüche

1. Elektronisches Gerät (1) mit mindestens einem Halbleiterchip (2) , der an mindestens einer Kontaktseite flächig mit wenigstens einem metallischen Leiterteil (3) elektrisch leitend verbunden ist, wobei das Leiterteil (3) an seiner dem Halbleiterchip (2) abgewandten Rückseite flächig mit einem metallischen Wärmeableitkörper (5) verbunden ist, und wobei zwischen dem Leiterteil (3) und dem Wärmeableitkörper (5) eine elektrisch isolierende Folie (6) angeordnet ist, **dadurch gekennzeichnet, dass** zwischen der Folie (6) und dem Leiterteil (3) und/oder zwischen der Folie (6) und dem Wärmeableitkörper (5) eine weiche metallische Schicht (7, 9) angeordnet ist.

2. Elektronisches Gerät (1) nach Anspruch 1, **dadurch gekennzeichnet, dass** mindestens eine metallische Schicht (7, 9) durch ein vorzugsweise weichgeglühtes Metallband gebildet ist.

3. Elektronisches Gerät (1) nach Anspruch 1 oder 2, **dadurch gekennzeichnet, dass** die Folie auf das Metallband aufkaschiert ist.

4. Elektronisches Gerät (1) nach einem der Ansprüche 1 bis 3, **dadurch gekennzeichnet, dass** mindestens eine metallische Schicht (7, 9) aus einem pastösen Werkstoff besteht.

5. Elektronisches Gerät (1) nach einem der Ansprüche 1 bis 4, **dadurch gekennzeichnet, dass** wenigstens zwei Leiterteile (3) seitlich durch mindestens einen Zwischenraum (4) derart voneinander beabstandet sind, dass sie eine mehrere Leiterbahnen aufweisende Leiterbahnstruktur bilden, und dass die zwischen der Folie (6) und den Leiterteilen (3) angeordnete metallische Schicht eine Struktur aufweist, die der Leiterbahnstruktur angepasst und vorzugsweise etwa deckungsgleich mit dieser ist.

6. Elektronisches Gerät (1) nach einem der Ansprüche 1 bis 5, **dadurch gekennzeichnet, dass** zumindest in dem mindestens einen Zwischenraum (4) eine elektrisch isolierende Vergussmasse (11) angeordnet ist, vorzugsweise ein Lack.

7. Elektronisches Gerät (1) nach einem der Ansprüche 1 bis 6, **dadurch gekennzeichnet, dass** die Dicke der Folie (6) zwischen 12,5 µm und 25 µm beträgt.

8. Elektronisches Gerät (1) nach einem der Ansprüche 1 bis 7, **dadurch gekennzeichnet, dass** zwischen der Folie (6) und dem Leiterteil (3) eine vorzugsweise als Klebstoffschicht (8) ausgebildete Zwischenschicht angeordnet ist, die an ihrer einen Seite das Leiterteil (3) und an ihrer anderen Seite die Folie (6) und/oder die zwischen dem Leiterteil (3) und der Folie (6) angeordnete metallische Schicht (7) stoffschlüssig kontaktiert.

9. Elektronisches Gerät (1) nach einem der Ansprüche 1 bis 8, **dadurch gekennzeichnet, dass** zwischen der Folie (6) und dem Wärmeableitkörper (5) eine vorzugsweise als Klebstoffschicht (10) ausgebildete Zwischenschicht angeordnet ist, die an ihrer einen Seite den Wärmeableitkörper (5) und an ihrer anderen Seite die Folie (6) und/oder die zwischen dem Wärmeableitkörper (5) und der Folie (6) angeordnete metallische Schicht (9) stoffschlüssig kontaktiert.

10. Elektronisches Gerät (1) nach einem der Ansprüche 1 bis 9, **dadurch gekennzeichnet, dass** die Zwischenschicht Metallpartikel und/oder Keramikpartikel enthält.
